# EUROPEAN PATENT SPECIFICATION

(11) **EP 1 928 033 B1**
(45) Date of publication and mention of the grant of the patent: **12.07.2017**
(21) Application number: 07023094.1
(22) Date of filing: 28.11.2007
(51) Int. Cl.: H01L 33/62, H01L 33/48, H01L 25/075

(54) **Light-emitting apparatus and method of producing the same**
Lichtemittierende Vorrichtung und Herstellungsverfahren dafür
Dispositif électroluminescent et son procédé de fabrication

(30) Priority: 30.11.2006 JP 2006324978
(43) Date of publication of application: 04.06.2008
(73) Proprietor: Nichia Corporation, Anan-shi Tokushima 774-8601 (JP)
(72) Inventor: Hoshiba, Toshiyuki, Anan-shi Tokushima 774-8601 (JP)
(74) Representative: Heusler, Wolfgang

(56) References cited:
- EP-A1- 1 681 729
- WO-A2-02/084749
- JP-A- 9 232 637
- JP-A- 2006 086 178
- JP-U- 62 047 156
- US-A1- 2002 070 387
- US-A1- 2005 057 144
- US-A1- 2005 280 017

## Description

The present invention relates to a light-emitting apparatus and a method of producing the same, and more particularly to an electrode structure of a packaged substrate in a resin-sealed emitting device mounting a semiconductor light-emitting device, and a method of producing the same, the electrode structure being used in, for example, a light-emitting apparatus for surface mounting.

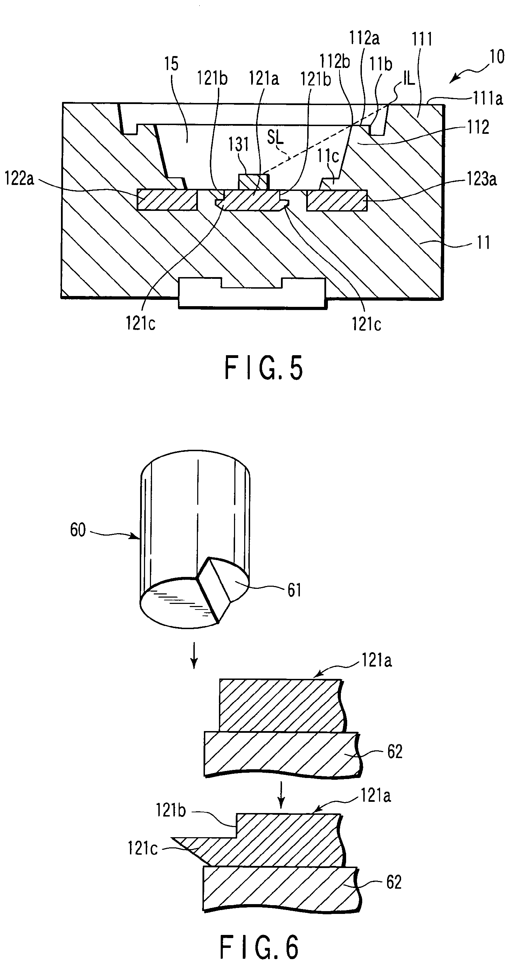

In a surface mounting resin-sealed light-emitting apparatus, a pair of lead electrodes is embedded in a cup portion of the resin package, as shown in, for example, FIGS. 6 to 8 of Jpn. Pat. Appln. KOKAI Publication No. 2006-86178. A light-emitting device is secured, through a paste, to the surface of one of the electrode placed at the central portion of the bottom of the cup portion by die-bonding. The light-emitting device and the other electrode are wire-bonded with each other. The resin sealing is established by filling an epoxy resin that has thermosetting property, in the cup.

In such a light-emitting apparatus, the epoxy resin and the lead electrodes are different from each other in expansion coefficient, and when the temperature of the device increases, for example, during reflow step in mounting process of the light-emitting apparatus, strains are generated in these parts by stresses due to the heat. The strains lead to peeling of the lead electrode from the molded epoxy resin.

Incidentally, as disclosed in Jpn. Pat. Appln. KOKAI Publication No. 2006-86178, peeling of the lead electrodes often begins at the rectangular or acute angular portions of the lead electrode. In other words, at the portions which abruptly change in the plane shape of the lead electrode, unbalanced thermal stresses are generated, often resulting in peeling of the lead electrode due to thermal strains.

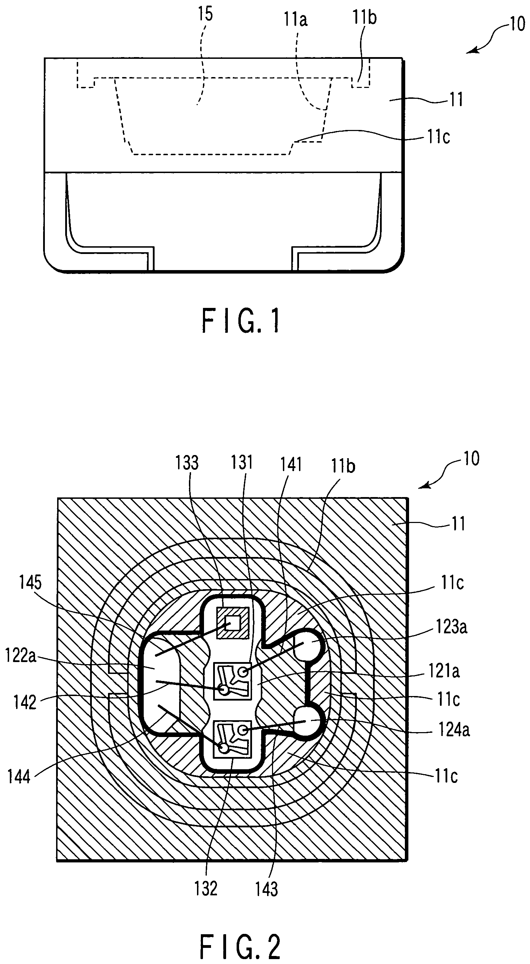

To solve the problems, Jpn. Pat. Appln. KOKAI Publication No. 2006-86178 discloses, in FIG. 1, designing the shape of the lead electrode so as to eliminate rectangular or acute angular portions of the lead electrode as much as possible, and making the corners of the upper plane of the lead electrode obtuse or curved.

Further, Jpn. Pat. Appln. KOKAI Publication No. 2006-86178 discloses, in FIG. 1, that a stepped portion is formed at the edge portion of the lead electrode, positioned below the paste through which the light-emitting device is secured, to make the thickness of the lead electrode at that portion thinner, thereby improving adhesion of the lead electrode and the molding resin and suppressing peeling of the lead electrode due to thermal strains. The upper portion of the edge portion of the lead electrode is rounded in cross section.

However, with the structure in which the upper portion of the edge portion of the lead electrode is rounded in cross section, when the temperature of the light-emitting apparatus increases and the sealing resin positioned above the bottom surface of the cup portion expands, adhesion of the lead electrode and molding resin is impaired, with the result that the edge portion of the lead electrode is peeled from and lifted off the molding resin, and the lead electrode shifts. Further, the edge portion of the lead electrode may lift off by the pressure applied to the lead electrode during wire bonding to the lead electrode.

On the other hand, Jpn. Pat. Appln. KOKAI Publication No. 2001-177160 discloses, in FIG. 5, forming stepped portions entirely on the outer surface of the inner edge portion of the lead frame in order to prevent the inner edge portion of the lead frame from lifting. However, if the stepped portions are formed entirely on the outer surface of the inner edge portion of the lead frame, the area of the lead frame is increased by the stepped portions, hindering the miniaturization of the light-emitting apparatus.

Further, Jpn. Pat. Appln. KOKAI Publication No. 2003-17753 discloses, in FIG. 1, placing three light-emitting devices of red, green and blue on a lead frame supported by a molding resin having a recess at the bottom plane of the recess, and filling a transparent epoxy resin in the recess.

Further, light-emitting apparatuses including a light-emitting device arranged in a resin package are disclosed in JP 62 047156 U, WO 02/084749 A2 and JP 9 232637 A. Another semiconductor light-emitting apparatus according to the preamble of claim 1 is disclosed in US 2005/0280017 A1, which comprises a resin package, a lead electrode held by the resin package, and a light-emitting device secured in the resin package, wherein the lead electrode has stepped portions for holding the lead electrode in the resin.

The present invention has been made to solve the above-mentioned problems of the prior art, and aims at providing a high reliability resin-sealed light-emitting device in which peeling of the lead electrode due to thermal strains can be prevented without enlarging the width of the electrode to prevent the lifting of the lead electrode, as well as a method of producing such a device at a low cost.

According to the present invention, there is provided a light-emitting apparatus having the features of claim 1, in which in particular a lead electrode is held by a resin package having a cup portion formed therein, a semiconductor light-emitting device is secured on the lead electrode within the cup portion, and a light-transmitting member is filled in the cup portion so as to seal the semiconductor light-emitting device, characterized in
that a recessed stepped portion is formed in that region of the upper surface of the lead electrode held by the resin package which is offset from the secured portion of the semiconductor light-emitting device, an edge portion of the bottom surface of the stepped portion laterally protrudes into the resin package, forming a flange portion, and a vertical cross section of the protruding edge portion forms an approximately acute angle.

Furthermore, there is described a light-emitting apparatus comprising: a resin package having a concave cup portion formed therein; a first lead frame having a first lead electrode which has an approximately rectangular plane, and is held by the resin package such that it is at least partially exposed at the bottom surface of the cup portion; a second lead frame arranged spaced apart from one side surface of the first lead frame and having a second lead electrode which is held in the resin package such that the second lead electrode is at least partially exposed at the bottom surface of the cup portion; a semiconductor light-emitting device secured on the first lead electrode with an adhesive and having an electrode; a first metallic thin wire electrically connected to the electrode of the semiconductor light-emitting device and to the second lead electrode; a light-transmitting member filled in the cup portion so as to seal the semiconductor light-emitting device; recessed stepped portions each formed in opposed sides of a region of the upper surface of the first lead electrode held by the resin package, said region being offset from the secured portion of the semiconductor light-emitting device; and flange portions each formed of the bottom surface portion of the stepped portion, said bottom surface portion laterally protruding into the resin package, the protruding edge portion of the bottom
surface portion forming an approximately acute angle in its vertical cross section.

Furthermore, there is described a light-emitting apparatus comprising: a resin package molded to have a concave cup portion formed therein; a first lead frame having a first lead electrode which has an approximately rectangular plane, and is held by the resin package such that it is at least partially exposed at the bottom surface of the cup portion; a second lead frame having a second lead electrode which is arranged spaced apart from one side surface of the first lead frame and is held in the resin package such that the second lead electrode is at least partially exposed at the bottom surface of the cup portion; a third lead frame having a third lead electrode which is arranged spaced apart from the other side surface of the first lead frame and is held in the resin package such that the third lead electrode is at least partially exposed at the bottom surface of the cup portion; a fourth lead frame having a fourth lead electrode which is arranged spaced apart from the other side surface of the first lead frame and is held in the resin package such that the fourth lead electrode is at least partially exposed at the bottom surface of the cup portion; a plurality of flange portions which laterally protrude from opposed side surface portions of the first lead electrode into the resin package, respectively, at positions facing the third and fourth lead electrodes, and each have a upper surface which is recessed from the upper surface of the first lead electrode to provide a step, the protruding edge portion of the flange portions each forming an approximately acute angle in their vertical cross section; first and second light-emitting devices each secured with an adhesive on a plurality of regions of the upper surface of the lead electrode, which regions are sectioned by the plurality of flange portions, the first and second light-emitting devices each having a pair of electrodes on its upper surface; a first metallic thin wire connected by bonding between one of the pair of electrodes of the first light-emitting device and the second lead electrode; a second metallic thin wire connected by bonding between the other of the pair of electrodes of the first light-emitting device and the third lead electrode; a third metallic thin wire connected by bonding between one of the pair of electrodes of the second light-emitting device and the second lead electrode; a fourth metallic thin wire connected by bonding between the other of the pair of electrodes of the second light-emitting device and the fourth lead electrode; and a light-transmitting sealing member filled in the cup portion so as to seal the semiconductor light-emitting devices.

In each aspect, it is preferred that the protruding edge portion of the flange is embedded in the resin package, and the bottom surface of the stepped portion is in a circular arc form.

It is possible to constitute the first lead frame by a metallic member, and to easily form the stepped portion and the flange by half pressing from the upper surface of the lead frame. In this case, it is preferred that the protruding edge portion of the flange is embedded in the resin package, and the bottom surface of the stepped portion is in a circular arc form.

Further, it is preferred that the resin package has a raised portion inwardly raising from its outermost peripheral portion, the upper surface of the raised portion is positioned lower than the upper surface of the outermost peripheral portion, and the inner upper edge of the raised portion is positioned on or above a straight line connecting (a) the line of intersection of the cup portion with the upper surface of the sealing member and (b) the semiconductor light-emitting device. Further, when the color of the resin package is dark, it is preferred that the resin package covers the lead electrode around the secured portion of the semiconductor light-emitting device and of the metallic wire, excluding the secured portions of the semiconductor light-emitting device and of the metallic wire.

According to the present invention, a method of producing a light-emitting apparatus comprises the features of claim 8, in which in particular a lead electrode constituted by a metallic member is held by a resin package having a cup portion formed therein, a semiconductor light-emitting device is secured on the upper surface of the lead electrode, the cup portion is filled with a light-transmitting member, a recessed stepped portion is formed in that region of the upper surface of the lead electrode held by the resin package which is offset from the secured portion of the semiconductor light-emitting device, and the bottom surface of the stepped portion laterally protrudes into the resin package to form a flange, the protruding edge portion of the flange forming an approximately acute angle in its vertical cross section, characterized in that before molding the resin package so as to hold the lead electrode, half pressing is conducted from the above onto an edge portion of the upper surface of the lead electrode to form the stepped portion and the flange simultaneously in the same step.

Furthermore, there is described a method of producing a light-emitting apparatus, the apparatus comprising a resin package having a concave cup portion formed therein; a first lead frame having a first lead electrode which has an approximately rectangular plane, and is held by the resin package such that it is at least partially exposed at the bottom surface of the cup portion; a second lead frame arranged spaced apart from one side
surface of the first lead frame and having a second lead electrode which is held in the resin package such that the second lead electrode is at least partially exposed at the bottom surface of the cup portion; a semiconductor light-emitting device secured on the first lead electrode with an adhesive and having an electrode; a first metallic thin wire electrically connected to the electrode of the semiconductor light-emitting device and to the second lead electrode; a light-transmitting member filled in the cup portion so as to seal the semiconductor light-emitting device; recessed stepped portions each formed in opposed sides of a region of the upper surface of the first lead electrode held by the resin package, said region being offset from the secured portion of the semiconductor light-emitting device; and flange portions each formed of the bottom surface portion of the stepped portion, said bottom surface portion laterally protruding into the resin package, the protruding edge portion of the bottom surface portion forming an approximately acute angle in its vertical cross section, characterized in that before molding the resin package so as to hold the lead electrode, half pressing is conducted from the above onto an edge portion of the upper surface of the lead electrode to form the stepped portion and the flange simultaneously in the same step.

In the light-emitting apparatus according to the present invention, since there is formed a flange portion laterally protruding into the resin package from the side surface of the lead electrode on which the semiconductor light-emitting device is secured, and the flange portion has a substantially acute angular cross section in its protruding edge portion, lifting or peeling of the lead electrode due to thermal strains, etc., can be prevented without fail, realizing a high reliability light-emitting apparatus. Furthermore, since the flange portion is formed only at the region of the upper surface of the lead electrode, offset from the secured portion of the light-emitting device, the enlargement of the electrode width is not required, as compared to the case where the flange portion is formed entirely on the side surface.

Further, since the recessed stepped portion 121b is present on a portion of the upper surface of the lead electrode 121a, corresponding to the position of the flange portion 121c, flowing-out (spreading) of the adhesive for securing the semiconductor light-emitting device can be restricted. In other words, since the stepped portion is covered by the resin package, and a portion of the lead electrode is inwardly depressed, the inward depression can prevent the die bonding resin from laterally flowing out, and suppress lifting of the lead electrode.

Further, the provision of the recessed stepped portion 121b is advantageous in that the lead electrode 121a is little distorted, compared to the case where a slit is provided in the peripheral region of the lead electrode, penetrating through the lead electrode in the thickness direction. In addition, since the recessed stepped portion is of a circular arc shape in its contour when viewed from the upper surface, it is easily made by half pressing.

Further, it is preferable the resin package has a raised portion inwardly raising from its outermost peripheral portion, the upper surface of the raised portion is positioned lower than the upper surface of the outermost peripheral portion, and the inner upper edge of the raised portion is positioned on or above a straight line connecting (a) the line of intersection of the cup portion with the upper surface of the sealing member and (b) the semiconductor light-emitting device, as mentioned above. With such an inner wall, it is possible to prevent the light emitted from the semiconductor light-emitting device from directly illuminating the portion corresponding to the line of intersection noted above, thereby suppressing the peeling between the light-transmitting sealing resin and the resin package.

Further, when the color of the resin package is dark, contrast is improved by covering each lead electrode around the secured portion of the light-emitting device and of the metal wiring, excluding the secured portion of the light-emitting device and of the metal wiring.

Furthermore, in the method of producing a light-emitting apparatus according to the present invention, since half pressing is conducted from the upper surface of the lead electrode onto the upper edge surface portion of the lead electrode, the stepped portion and the flange can be easily prepared in the same step. In this case plural stepped portions and flanges can be formed simultaneously or sequentially.

The invention can be more fully understood from the following detailed description when taken in conjunction with the accompanying drawings, in which:
FIG. 1 is a partially perspective side view illustrating a light-emitting apparatus according to a first embodiment of the present invention;
FIG. 2 is a plan view illustrating the upper plane of the light-emitting apparatus shown in FIG. 2;
FIG. 3 is a plan view illustrating a resin package and lead frames;
FIG. 4 is a plan view illustrating one example of a pattern of the inner lead portions shown in FIG. 2;
FIG. 5 is a cross-sectional view schematically illustrating the cross-section along the line A-A in FIG. 4; and
FIG. 6 is an oblique view illustrating how recessed stepped portions and flange portions are formed at the lead electrode by half press from the upper plane of the lead electrode in producing a light-emitting apparatus according to the first embodiment of the present invention.

Embodiments of the present invention will be described below with reference to the drawings. It should be noted that the following embodiments exemplify a light-emitting apparatus embodying the technical idea of the present invention and the present invention should not be limited thereto. Further, the description herein is not intended to restrict the members or elements recited in the claims to those described in the embodiments. In particular, the sizes, materials, shapes and relative arrangements of the members or elements described in the embodiments are not intended to restrict the claims thereto and are only illustrative examples. The sizes and positional relationships of the members in the drawings are sometimes shown exaggerated. Further, a plurality of elements constituting the present invention may be constituted by one and the same member, which exhibits the functions of the plurality of elements, or conversely, the functions of one member may be shared by a plurality of members.

Embodiments of the present invention will be described below with reference to the drawings. In the following description, the same names and reference symbols denote the same or similar elements, and their detailed explanation may be omitted in the subsequent description.

### <First Embodiment>

### Structure of Light-Emitting Apparatus

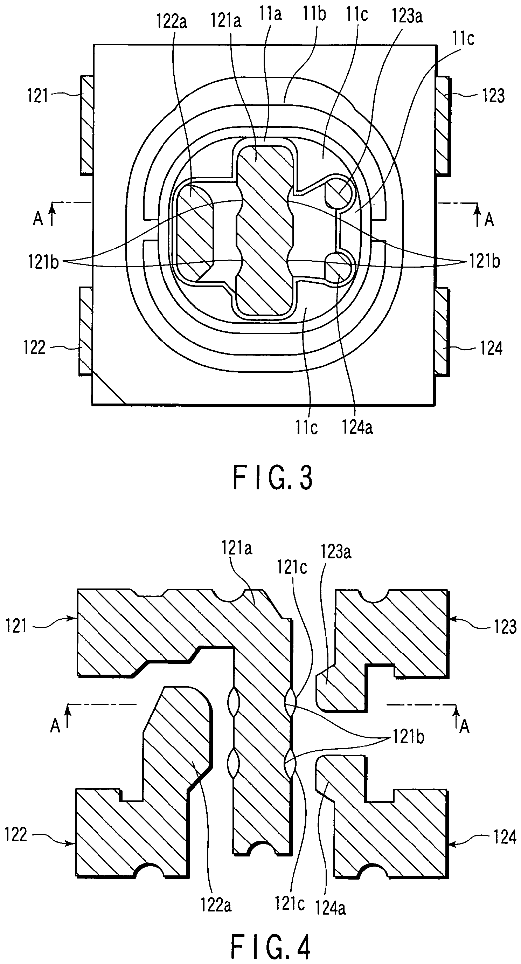

FIG. 1 is a partially perspective side view illustrating a light-emitting apparatus according to a first embodiment of the present invention. FIG. 2 is a plan view illustrating the upper plane of the light-emitting apparatus shown in FIG. 2. FIG. 3 is a plan view illustrating a resin package and lead frames. FIG. 4 is a plan view illustrating one example of a pattern of the inner lead portions shown in FIG. 2. FIG. 5 is a cross-sectional view schematically illustrating the cross-section along the line A-A in FIG. 4.

First, the structure of the light-emitting apparatus will be described with reference to FIGS. 1 to 5. In this light-emitting apparatus 10, when an insulating resin package 11 is molded so as to have a concave cup portion (opening portion) 11a, first to fourth lead electrodes 121a to 124a, which are parts of the inner leads of first to fourth lead frames 121 to 124 formed of electrically conductive member, are held in a state embedded in the resin such that they are exposed at the bottom surface of the cup portion partially or entirely. In this embodiment, each of lead frames 121 to 124 is folded along the outer plane of the resin package so as to provide, for example, an outer terminal suitable for surface mounting. For example, the outer leads of the first to fourth lead frames are correspondingly used as first to fourth outer terminals, while the second lead frame 122 is used as a lead frame for a common outer terminal.

Semiconductor light-emitting devices (in this embodiment, light-emitting diodes (LEDs)) 131, 132 and 133 are secured on the lead electrode 121a within the cup portion 11a by an adhesive (e.g., a die bonding member, not shown).

At those portions of the upper edge surface of the first lead electrode 121a held by the resin package 11, which correspond to the regions of the first lead electrode offset from the secured portions of LEDs 131, 132 and 133, stepped or recessed portions 121b are formed in the upper edge surface portion of the first lead electrode 121 (see FIGS. 2 to 5). The bottom surfaces of the stepped portions form flanges 121c laterally protruding into the resin package 11. In other words, the flange portion is integrally formed with the first lead electrode 121a, and the cross section of the protruding edge portion is in an acute angular form (see FIG. 5). The depth of the recessed stepped portion 121b is desirably about half the thickness of the first lead electrode 121a. The recessed stepped portion refers to a portion dented below the upper surface of the lead electrode on which the semiconductor light-emitting device is mounted. Further, since the edge portion of the bottom surface of the stepped portion forms the flange portion laterally protruding into the resin package, the protruding edge portion of the bottom surface of the stepped portion is embedded in the resin package 11. In this case, the upper surface portion of the resin package, corresponding to the stepped portion, is preferably made substantially flush with the upper surface of the lead electrode.

Metal thin wires 141 to 145 are bonded to electrically connect the LEDs 131, 132 and 133 with the second to fourth lead electrode 122a to 124a, respectively, as desired. A light-transmitting member (a sealing resin in this embodiment) 15 is filled in the cup portion so at to seal the LEDs 131, 132 and 133, as well as the metal thin wires 141 to 145.

Next, the structures and elements or members shown in FIGS. 1 to 5 will be described in detail. In the light-emitting apparatus described above, the cup portion 11a formed in the resin package 11 has a shape of a reversed circular truncated cone, and its bottom surface includes the upper surfaces of the lead electrodes 121a to 124a partially or entirely. The first lead electrode 121a has a substantially rectangular plane. The second lead electrode 122a is arranged space apart from one side of the first lead electrode 121a. The third lead electrode 123a and the fourth lead electrode 124a are juxtaposed and spaced apart from the other side of the first lead electrode 121a.

Further, in portions of the upper edge surface portion of the first lead electrode 121a held by the resin package 11, recessed stepped portions 121b are formed, and the flange portions 121c each having an upper surface constituting the same plane with the bottom surface of the stepped portions protrude from the side face of the lead electrode 121a.

In this embodiment, at the positions at which the side face of the lead electrode 121a faces the third lead electrode 123a and the fourth lead electrode 124a, a pair of flange portions 121c is formed on either side face of the first lead electrode 121a. Each flange portion 121c is formed so as to have a substantially acute angular, vertical cross-section in the protruding edge portion, and laterally protrudes into the resin package. In other words, the bottom surface of the stepped portion 121b and the flange portion of the first lead electrode are covered by the resin package 11.

On a plurality of regions of the first lead electrode 121a, sectioned by the plurality of stepped portions 121b formed in either side face of the lead electrode 121a, a plurality of LEDs 131, 132 and 133 are separately placed. In other word, the recessed stepped portion 121b of the first lead electrode 121a is provided offset from the secured portion of the LEDs on the first lead electrode. In this embodiment, the first and second LED 131 and 132 each having a pair of electrodes on its upper surface are secured on the first lead electrode 121a with adhesive (die bonding member) having a good thermal conductivity, respectively. The third LED 133 having a pair of electrodes separately provided on its upper and lower surfaces is secured on the firs lead electrode 121a with an electrically conductive adhesive (e.g., electrically conductive paste).

A first metallic thin wire 141 is connected by bonding to the one of the pair of electrodes of the first LED 131 and to the third lead electrode 123a, while a second metallic thin wire 142 is connected by bonding to the other electrode of the first LED 131 and to the second lead electrode 122a. A third metallic thin wire 143 is connected by bonding to the one of the pair of electrodes of the second LED 132 and to the fourth lead electrode 124a, while a fourth metallic thin wire 144 is connected by bonding to the other electrode of the second LED 132 and to the second lead electrode 122a. Further, a fifth metallic thin wire 145 is connected by bonding to the electrode on the upper surface of the third LED 133 and to the second lead electrode 122a.

The light-emitting apparatus of the invention having the structure described above has the
flange portions 121c laterally protruding into the resin package from the side face portions of the lead electrode 121a on which the semiconductor light-emitting device is secured, and each flange portion has a substantially acute angular, vertical cross section in its protruding edge. This constitution enables to prevent lifting or peeling of the lead electrode 121a due to thermal strains or the pressure applied to the lead electrodes during wire bonding to the lead electrodes, without fail, and thus the lead electrode does not shift or move, realizing a high reliability.

Furthermore, since the flange portions 121c are formed only at the regions of the side faces of the lead electrode, offset from the secured portion of the light-emitting device, the enlargement of the electrode width is not required, as compared to the case where the flange portion is formed entirely on the side surfaces. The flange portions 121c and the recessed stepped portions 121b continuing thereinto can be formed easily by the same half pressing step.

Since the recessed stepped portions 121b are formed in portion of the upper edge surface portions of the lead electrode 121a, corresponding to the position of the flange portion 121c, flowing-out (spreading) of the adhesive for securing the semiconductor light-emitting device can be restricted. In other words, since the stepped portions are covered by the resin package, and a portion of the lead electrode is inwardly depressed, the inward depression can prevent the die bonding resin from laterally flowing out, and suppress lifting of the lead electrode.

Compared to the case where a slit is provided in the peripheral region of the lead electrode 121a, penetrating through the lead electrode 121a in the thickness direction, the provision of the recessed stepped portions 121b is advantageous in that the lead electrode 121a is little distorted. In addition, since the recessed stepped portions 121b are of a circular arc shape in its contour when viewed from the upper surface, it is easily made by half pressing.

In the first embodiment described above, it is desirable for each lead electrode to have a substantial number of protrusions (not shown) on its bottom surface in order to increase the contact area with the resin package.

It is preferable that the resin package 11 has a raised portion 112 inwardly raising from its outermost peripheral portion 111, the upper surface 112a of the raised portion 111 is positioned lower than the upper surface 111a of the outermost peripheral portion 111, and the inner upper edge 112b of the raised portion 112 is positioned on or above a straight line SL connecting (a) the line of intersection IL of the cup portion 11c with the upper surface of the sealing member 15 and (b) the semiconductor light-emitting device 131 (see FIG. 5). In this case, of the plural LEDs 131, 132 and 133, the LED 131, which is shortest in the emission peak wavelength, is selected as a benchmark. Further, when plural LEDs are used, it is preferable to provide a stepped portion 11b between upper edge surface of the cup portion 11a and the upper edge surface of the resin package 11. With such a structure, it is possible to prevent the light emitted from the LED 131 from directly illuminating the outer most peripheral portion of the resin package 11, thereby suppressing the peeling between the light-transmitting sealing resin 15 and the resin packages 11.

In order to improve the contrast of the output light, the areas of the lead electrodes 121a to 124a at the bottom surface of the cup portion 11a are of great concern. When the color of the resin package 11 is dark, it is desirable to cover the lead electrodes 121a to 124a, except for their device secured portions and metallic wire secured portions, with a portion 11c of the resin package 11.

Next, some of constitutional elements in the first embodiment mentioned above will be described below.

### LEDs 131, 132 and 133

As LEDs, those having a semiconductor such as GaAlN, ZnS, ZnSe, SiC, GaP, GaAlAs, AlN, InN, AlInGaP, InGaN, GaN or AlInGaN, as a light-emitting layer formed on a substrate may be used. The LED may be of a homo structure, hetero structure or double-hetero structure, having a MIS, PIN or PN junction. The emission wavelength may vary from ultraviolet to infrared by appropriately selecting the materials or the compositions thereof used for the light-emitting layer. The light-emitting layer may be of a single quantum well structure or a multiple quantum well structure, generating quantum effect.

When the light-emitting apparatus is used outdoors, it is preferable to use gallium nitride-based semiconductor materials, which are capable of producing high luminance light-emitting devices. In the red light-emitting device, it is preferable to use gallium aluminum arsenide or aluminum indium gallium phosphorus semiconductor materials, but any other semiconductor materials may be used depending on applications.

When a gallium nitride-based semiconductor material is used, sapphire, spinel, SiC, Si, ZnO or GaN single crystal is used as the material for the substrate. In order to form gallium nitride of a good crystal quality with good mass productivity, it is preferable to use a sapphire substrate.

A plurality of LEDs may be used as desired, and a variety of light-emitting apparatus can be realized by appropriately combining the emission colors of the LEDs and arranging the LEDs. For example, a dot matrix arrangement or a linear arrangement may be used, thereby obtaining a light-emitting apparatus having a very high packaging density and excellent heat removing property. When the apparatus is used as a full-color light-emitting apparatus for a display device, it is preferable to combine a red light-emitting device having an emission wavelength of 610 nm to 700 nm, a green light-emitting device having an emission wavelength of 495 nm to 565 nm, and a blue light-emitting device having an emission wavelength of 430 nm to 490 nm. Further, when the light-emitting apparatus is caused to emit mixed color light such as white light by using a phosphor material, the emission wavelength is preferably 400 nm or more and 530 nm or less, more preferably 420 nm or more and 490 nm or less, taking the complementary color relationship with the emission wavelength of the phosphor material and deterioration of the light-transmitting resin into consideration. In order to further improve the excitation of the light-emitting device and the phosphor material, and to improve the emission efficiency, the emission wavelength is more preferably 450 nm or more and 475 nm or less. An LED having a main emission wavelength in the ultraviolet region shorter than 400 nm, or in the short wavelength region of the visible light may be used, when combined with the materials which are relatively hardly deteriorated by the ultraviolet ray.

### Resin Package 11

The resin package has the LED chips arranged therein and has a lead electrode for supplying current to the LED chips from the outside. Therefore, suitably, the resin package has heat resistant and electrically insulating properties. Suitable specific examples of the material for such a resin package include glass-epoxy, bismaleimide triazine, ceramics, liquid crystal polymer and polybutylene terephthalate. The resin for the resin package may contain white pigment such as titanium oxide in order to efficiently reflect the light from the LED chip. When the resin package is molded from a resin, the lead electrode may be simply attached by inset molding.

### Lead Frames 121 to 124 and Lead Electrodes 121a to 124a

It is desirable to use, for the lead frames 121 to 124, metallic members having a good electrical conductivity and excellent adhesion with the light-transmitting sealing resin 15. Examples of such a member include a metal such as iron, copper or aluminum, an alloy such as iron-added copper or stainless steel. These metallic materials may be plated with various metals such as gold, silver or platinum. The lead frames may be fabricated by, for example, punching of a metal plate.

### Light-transmitting sealing member 15

The light-transmitting sealing member 15 is used to protect the LEDs, thin wires, etc. from the external force exerted from the external environment, and from dusts and moisture, and may be formed of a material excellent in light fastness and in light transmissivity, including an organic material such as an epoxy resin, a silicone resin, a modified silicone resin, an acrylic resin or an imide resin, and an inorganic material such as glass. Further, the light-transmitting member may contain aluminum oxide, barium oxide, barium titanate, silicon oxide or titanium oxide in order to diffuse the light from the semiconductor light-emitting device. Also, the light-transmitting member may contain a colorant to have a filer effect cutting the foreign light and the unnecessary wavelengths form the semiconductor light-emitting device. Furthermore, the light-transmitting member may contain a phosphor material which is excited by the emission wavelength from the semiconductor light-emitting device to produce fluorescence. The directionality of the light emitted from the semiconductor light-emitting device can be changed by changing the shape of the light-transmitting member. Further, the light-transmitting member may have a lens effect by shaping it into a convex lens shape or a concave lens shape.

### Method of Producing the Light-Emitting Apparatus

FIG. 6 is an oblique view schematically illustrating how the recessed stepped portion and the flange portion are formed on the lead electrode by half-pressing from the upper surface of the lead electrode.

The light-emitting apparatus 10 according to the first embodiment may be basically produced by a method substantially the same as the method of producing the prior art light-emitting apparatuses. In the method according to this embodiment, before the resin package 11 is molded so as to hold the lead electrode 121a, half pressing from the upper surface of the lead electrode 121a is conducted to form the recessed stepped portion 121b and the flange portion 121c in the same step on a press platen 62.

In this case, a press plane 61 having a circular arc-shaped edge portion may be used to form the recessed stepped portion 121b having a circular arc-shaped contour on the upper surface of the lead electrode 121a, and the flange portion 121c, as illustrated in FIG. 6. The press plane 61 may be provided by removing a portion of an end face of a circular cylinder 60 to an appropriate depth. When a plurality of press planes is used in half pressing, recessed stepped portions 121b and flange portion 121c can be formed at a plurality of positions at the same time.

According to the method described above, the light-emitting apparatus of the present invention can be produced at a low cost.

### Other Embodiments

The present invention can be applied to not only a light-emitting apparatus mounting a plurality of light-emitting devices (two-in-one package type, three-in-one package type, etc.), but also to a one-in-one package type light-emitting apparatus (not shown). Further, the present invention can also be applied to a light-emitting apparatus of the structure in which a pair of electrodes is separately place on the upper and lower surface of a semiconductor light-emitting device is secured through an electrically conductive adhesive on the first lead electrode, thus electrically connecting the lower electrode to the first lead electrode, while the upper electrode of the semiconductor light-emitting device is electrically connected to the second lead electrode through a metallic wiring.

Furthermore, a semiconductor light-emitting device may be arranged such that the diagonal line of the rectangular upper plane of the semiconductor light-emitting device becomes perpendicular to one side of the lead electrode. This arrangement can narrow the distance between two adjacent recessed stepped portions or the distance between two opposedly facing recessed stepped portions.

Also, the light-emitting apparatus of the present invention is additionally provided with, e.g., Zener diode as a protective element, which is connected in parallel to the LED. In this case, the Zener diode may be placed on the lead electrode as in the case of the LED, or the LED may be placed on this Zener diode.

The present invention should not be limited to the embodiments described above, and may be modified in various ways within the scope of the claims. It should be noted that such modifications are also within the scope of the present invention.

### Example

In the light-emitting apparatus shown in FIGS. 1 to 5, nylon is used as a resin for molding the resin package 11, silver-plated copper is used for lead frames 121 to 124, and a silicone resin is used as the sealing resin 15. The outer size of the resin package is about 3 × 3 × 1.8 mm, and the depth of the cup portion (cavity) is about 0.8 mm. The lead frame has a light-emitting device-mounting portion of about 0.85 × 0.75 mm (width), and its bended portion has a width of about 0.75 mm. The stepped portion formed between the upper end face of the cup portion and the upper edge face of the resin package has a depth of about 0.15 mm and a width of 0.2 mm. As LEDs 131, 132 and 133, LEDs of three colors for full-color display are used.

The present invention may be applied generally to a resin-sealed light-emitting apparatus, without limiting to a light-emitting apparatus used as a light source of a backlight for a liquid crystal display screen of a mobile phone, character display panel used indoors or outdoors such as a full-color large scale graphic display device, a display capable of displaying various data, a sensor such as a line sensor, an indicator, etc.

## Claims

1. A light-emitting apparatus (10) comprising:
a resin package (11) having a concave cup portion (11a) formed therein,
a lead electrode (121a) held by the resin package (11), wherein the lead electrode (121a) has an upper surface and a bottom surface,
a semiconductor light-emitting device (131) secured on the upper surface of the lead electrode (121a) within the cup portion (11a), and
a light-transmitting member (15) filled in the cup portion (11a) so as to seal the semiconductor light-emitting device (131), wherein
one or more pairs of opposite recessed stepped portions (121b) dented from the upper surface of the lead electrode (121a) are formed at side face portions of said lead electrode (121a) and held by the resin package (11), wherein the semiconductor light-emitting device (131) is secured on a region offset from the one or more regions between the one or more pairs of said recessed stepped portions (121b),
protruding edge portions (121c) of the bottom surface of the recessed stepped portions (121b) protrude laterally into the resin package (11), wherein the upper surface of each protruding edge portion (121c) is formed by the bottom surface of the corresponding recessed stepped portion (121b), and the protruding edge portions (121c) are embedded in the resin package (11), and
an angle formed by an upper surface and a bottom surface of each of the protruding edge portions (121c) is an acute angle in vertical cross section to the upper surface of the lead electrode (121a),
**characterized in that**
the one or more pairs of the protruding edge portions (121c) laterally protrude into the resin package (11) from the side face portions of the same lead electrode (121a), on which the semiconductor light-emitting device (131) is secured.

2. The apparatus (10) according to claim 1, further comprising:
a first lead frame (121) having the lead electrode (121a) as a first lead electrode which has an substantially rectangular plane, and is held by the resin package (11) such that it is at least partially exposed at the bottom surface of the cup portion (11a), the semiconductor light-emitting device (131) being secured on the first lead electrode (121a) with an adhesive and having an electrode;
a second lead frame (122) arranged spaced apart from one side surface of the first lead frame (121) and having a second lead electrode (122a) which is held in the resin package (11) such that the second lead electrode (122a) is at least partially exposed at the bottom surface of the cup portion (11a); and
a first metallic thin wire (142) electrically connected to the electrode of the semiconductor light-emitting device (131) and to the second lead electrode (122a);
wherein the recessed stepped portions (121b) are each formed in opposed sides of the upper surface of the first lead electrode (121a).

3. The apparatus (10) according to claim 2, further comprising:
a third lead frame (123) having a third lead electrode (123a) which is arranged spaced apart from the other side surface of the first lead frame (121) and is held in the resin package (11) such that the third lead electrode (123a) is at least partially exposed at the bottom surface of the cup portion (11a);
a fourth lead frame (124) having a fourth lead electrode (124a) which is arranged spaced apart from the other side surface of the first lead frame (121) and is held in the resin package (11) such that the fourth lead electrode (124a) is at least partially exposed at the bottom surface of the cup portion (11a), the protruding edge portions (121c) are at positions facing the third and fourth lead electrodes (123a, 124a);
first and second light-emitting devices (131, 132) each secured with an adhesive on a plurality of regions of the upper surface of the first lead electrode (121a), which regions are sectioned by the protruding edge portions (121c), the first and second light-emitting devices (131, 132) each having a pair of electrodes on its upper surface, the first metallic thin wire (142) connected by bonding between one of the pair of electrodes of the first light-emitting device (131) and the second lead electrode (122a);
a second metallic thin wire (141) connected by bonding between the other of the pair of electrodes of the first light-emitting device (131) and the third lead electrode (123a);
a third metallic thin wire (144) connected by bonding between one of the pair of electrodes of the second light-emitting device (132) and the second lead electrode (122a); and
a fourth metallic thin wire (143) connected by bonding between the other of the pair of electrodes of the second light-emitting device (132) and the fourth lead electrode (124a).

4. The apparatus (10) according to any one of claims 1 to 3, **characterized in that** the bottom surface of the recessed stepped portions (121b) are in a circular arc form.

5. The apparatus (10) according to any one of claims 1 to 3, **characterized in that** the lead electrode (121a) is constituted by a metallic member, and that the depth of the recessed stepped portions (121b) are about half the thickness of the lead electrode (121a).

6. The apparatus (10) according to any one of claims 1 to 3, **characterized in that** the resin package (11) has an inner wall (112) between an upper edge surface of the cup portion (11a) and an outermost peripheral portion (111) of the resin package (11), the upper surface (112a) of the inner wall (112) is positioned lower than the upper surface (111a) of the outermost peripheral portion (111), and the inner upper edge (112b) of the inner wall (112) is positioned on or above a straight line (SL) connecting (a) the line of intersection (IL) of the cup portion (11a) with the upper surface of the light-transmitting member (15) and (b) the semiconductor light-emitting device (131).

7. The apparatus (10) according to any one of claims 1 to 3, **characterized in that** the color of the resin package (11) is dark, and that the resin package (11) covers the lead electrode (121a) around the secured portion of the semiconductor light-emitting device (131) and of the metallic wire (142), excluding the secured portion of the semiconductor light-emitting device (131) and of the metallic wire (142).

8. A method of producing a light-emitting apparatus according to one of the foregoing claims, **characterized in that** before molding the resin package (11) so as to hold the lead electrode (121a), half pressing which is to press from the upper surface of the lead electrode (121a) so as to form a stepped portion is conducted to form the recessed stepped portions (121b) and the protruding edge portions (121c) simultaneously in the same step.

9. The method according to claim 8, **characterized in that** the half pressing is conducted using a press plane (61) having a circular arc-shaped edge portion to form the recessed stepped portions (121b) having a circular arc-shaped contour on the upper surface of the lead electrode (121a).

## Patentansprüche

1. Lichtemittierende Vorrichtung (10), umfassend:
eine Harzeinheit (11) mit einem darin gebildeten konkaven Schalenbereich (11a),
eine Leitungselektrode (121a), die von der Harzeinheit (11) gehalten wird, wobei die Leitungselektrode (121a) eine obere Fläche und eine untere Fläche aufweist,
eine lichtemittierende Halbleitereinrichtung (131), die auf der oberen Fläche der Leitungselektrode (121a) innerhalb des Schalenbereichs (11a) gesichert ist, und
ein Lichtübertragungselement (15), das in den Schalenbereich (11a) zum Abdichten der lichtemittierenden Halbleitereinrichtung (131) gefüllt ist, wobei
ein oder mehrere Paare von gegenüberliegenden vertieften gestuften Teilbereichen (121b), die von der oberen Fläche der Leitungselektrode (121a) aus vertieft sind, an Seitenflächenbereichen der Leitungselektrode (121a) gebildet und von der Harzeinheit (11) gehalten sind, wobei die lichtemittierende Halbleitereinrichtung (131) an einem Bereich versetzt zu dem einen oder mehreren Bereichen zwischen dem einen oder den mehreren Paaren der vertieften gestuften Teilbereiche (121b) gesichert ist,
vorstehende Kantenbereiche (121c) der unteren Fläche der vertieften gestuften Teilbereiche (121b) seitlich in die Harzeinheit (11) vorstehen, wobei die obere Fläche jedes vorstehenden Kantenbereichs (121c) von der unteren Fläche des entsprechenden vertieften gestuften Teilbereichs (121b) gebildet ist, und die vorstehenden Kantenbereiche (121c) in der Harzeinheit (11) eingebettet sind, und
ein Winkel, der von einer oberen Fläche und einer unteren Fläche von jedem der vorstehenden Kantenbereiche (121c) gebildet ist, ein spitzer Winkel im Vertikalquerschnitt zu der oberen Fläche der Leitungselektrode (121a) ist,
**dadurch gekennzeichnet, dass**
das eine oder die mehreren Paare der vorstehenden Kantenbereiche (121c) seitlich in die Harzeinheit (11) von den Seitenflächenbereichen der gleichen Leitungselektrode (121a), an der die lichtemittierende Halbleitereinrichtung (131) gesichert ist, vorstehen.

2. Vorrichtung (10) nach Anspruch 1, ferner umfassend:
einen ersten Leitungsrahmen (121), der die Leitungselektrode (121a) als eine erste Leitungselektrode, die eine im Wesentlichen rechteckige Fläche umfasst und von der Harzeinheit (11) gehalten ist, so dass er mindestens teilweise an der unteren Fläche des Schalenbereichs (11a) freiliegt, umfasst, wobei die lichtemittierende Halbleitereinrichtung (131) an der ersten Leitungselektrode (121a) mit einem Haftmittel gesichert ist und eine Elektrode umfasst;
einen zweiten Leitungsrahmen (122), der beabstandet zu einer Seitenfläche des ersten Leitungsrahmens (121) angeordnet ist und eine zweite Leitungselektrode (122a) umfasst, die in der Harzeinheit (11) gehalten ist, so dass die zweite Leitungselektrode (122a) mindestens teilweise an der unteren Fläche des Schalenbereichs (11a) freiliegt; und
einen ersten metallischen dünnen Draht (142), der mit der Elektrode der lichtemittierenden Halbleitereinrichtung (131) und mit der zweiten Leitungselektrode (122a) elektrisch verbunden ist;
wobei die vertieften gestuften Teilbereiche (121b) jeweils in entgegengesetzten Seiten der oberen Fläche der ersten Leitungselektrode (121a) gebildet sind.

3. Vorrichtung (10) nach Anspruch 2, ferner umfassend:
einen dritten Leitungsrahmen (123), der eine dritte Leitungselektrode (123a) umfasst, die beabstandet von der anderen Seitenfläche des ersten Leitungsrahmens (121) angeordnet und in der Harzeinheit (11) gehalten ist, so dass die dritte Leitungselektrode (123a) mindestens teilweise an der unteren Fläche des Schalenbereichs (11a) freiliegt;
einen vierten Leitungsrahmen (124), der eine vierte Leitungselektrode (124a) umfasst, die beabstandet von der anderen Seitenfläche des ersten Leitungsrahmens (121) angeordnet und in der Harzeinheit (11) gehalten ist, so dass die vierte Leitungselektrode (124a) mindestens teilweise an der unteren Fläche des Schalenbereichs (11a) freiliegt, wobei die vorstehenden Kantenbereiche (121c) an Positionen vorgesehen sind, die der dritten und vierten Leitungselektrode (123a, 124a) zugewandt sind;
erste und zweite lichtemittierende Einrichtungen (131, 132), die jeweils mit einem Haftmittel an einer Mehrzahl von Bereichen der oberen Fläche der ersten Leitungselektrode (121a), wobei die Bereiche von den vorstehenden Kantenbereichen (121c) unterteilt sind, gesichert sind, wobei die ersten und zweiten lichtemittierenden Einrichtungen (131, 132) jeweils ein Elektrodenpaar auf deren oberer Fläche aufweisen, und der erste metallische dünne Draht (142) durch Verbinden zwischen einer Elektrode von dem Elektrodenpaar der ersten Lichtemittierungsvorrichtung (131) und der zweiten Leitungselektrode (122a) angeschlossen ist;
einen zweiten metallischen dünnen Draht (141), der durch Verbinden zwischen der anderen Elektrode des Elektrodenpaars der ersten lichtemittierenden Einrichtung (131) und der dritten Leitungselektrode (123a) angeschlossen ist;
einen dritten metallischen dünnen Draht (144), der durch Verbinden zwischen einer Elektrode des Elektrodenpaars der zweiten lichtemittierenden Einrichtung (132) und der zweiten Leitungselektrode (122a) angeschlossen ist; und
einen vierten metallischen dünnen Draht (143), der durch Verbinden zwischen der anderen Elektrode des Elektrodenpaars der zweiten lichtemittierenden Einrichtung (132) und der vierten Leitungselektrode (124a) angeschlossen ist.

4. Vorrichtung (10) nach einem der Ansprüche 1 bis 3, **dadurch gekennzeichnet, dass** die untere Fläche der vertieften gestuften Teilbereiche (121b) in einer Kreisbogenform vorgesehen ist.

5. Vorrichtung (10) nach einem der Ansprüche 1 bis 3, **dadurch gekennzeichnet, dass** die Leitungselektrode (121a) von einem metallischen Element gebildet ist und dass die Tiefe der vertieften gestuften Teilbereiche (121b) ungefähr eine Hälfte der Dicke der Leitungselektrode (121a) ist.

6. Vorrichtung (10) nach einem der Ansprüche 1 bis 3, **dadurch gekennzeichnet, dass** die Harzeinheit (11) eine Innenwand (112) zwischen einer oberen Kantenfläche des Schalenbereichs (11a) und einem äußersten Umfangsbereich (111) der Harzeinheit (11) umfasst, die obere Fläche (112a) der Innenwand (112) tiefer als die obere Fläche (111a) des äußersten Umfangsbereichs (111) ist, und die Innenoberkante (112b) der Innenwand (112) an oder über einer geraden Linie (SL), die (a) die Schnittlinie (IL) des Schalenbereichs (11a) mit der oberen Fläche des Lichtübertragungselement (15) und (b) die lichtemittierende Halbleitereinrichtung (131) verbindet, positioniert ist.

7. Vorrichtung (10) nach einem der Ansprüche 1 bis 3, **dadurch gekennzeichnet, dass** die Farbe der Harzeinheit (11) dunkel ist und dass die Harzeinheit (11) die Leitungselektrode (121a) um den gesicherten Bereich der lichtemittierenden Halbleitereinrichtung (131) und des metallischen Drahts (142) abdeckt, ausgenommen den gesicherten Bereich der lichtemittierende Halbleitereinrichtung (131) und des metallischen Drahts (142).

8. Verfahren zum Herstellen einer lichtemittierenden Vorrichtung nach einem der vorherigen Ansprüche, **dadurch gekennzeichnet, dass** bevor die Harzeinheit (11) zum Halten der Leitungselektrode (121a) gegossen wird, Halbpressen, das zum Pressen von der oberen Fläche der Leitungselektrode (121a) zum Bilden eines gestuften Bereichs ist, zum gleichzeitigen Bilden der vertieften gestuften Teilbereiche (121b) und der vorstehenden Kantenbereiche (121c) in demselben Schritt durchgeführt wird.

9. Verfahren nach Anspruch 8, **dadurch gekennzeichnet, dass** das Halbpressen unter Verwendung einer Pressfläche (161), die einen kreisbogenförmigen Kantenbereich aufweist, zum Bilden der vertieften gestuften Teilbereiche (121b), die eine kreisbogenförmige Kontur an der oberen Fläche der Leitungselektrode (121a) aufweisen, durchgeführt wird.

## Revendications

1. Appareil électroluminescent (10) comprenant :
un boîtier en résine (11) dans lequel est formée une portion de coupelle concave (11a),
une électrode de conduction (121a) tenue par le boîtier en résine (11), dans lequel l'électrode de conduction (121a) a une surface supérieure et une surface inférieure,
un dispositif électroluminescent à semi-conducteur (131) arrimé sur la surface supérieure de l'électrode de conduction (121a) au sein de la portion de coupelle (11a), et
un organe de transmission de lumière (15) remplissant la portion de coupelle (11a) de façon à sceller le dispositif électroluminescent à semi-conducteur (131),
dans lequel
une ou plusieurs paires de portions étagées en retrait opposées (121b) bosselées depuis la surface supérieure de l'électrode de conduction (121a) sont formées au niveau de portions de face de côté de ladite électrode de conduction (121a) et tenues par le boîtier en résine (11), dans lequel le dispositif électroluminescent à semi-conducteur (131) est arrimé sur une région décalée des une ou plusieurs régions entre les une ou plusieurs paires desdites portions étagées en retrait (121b),
des portions de bord saillantes (121c) de la surface inférieure des portions étagées en retrait (121b) font saillie latéralement dans le boîtier en résine (11),
dans lequel la surface supérieure de chaque portion de bord saillante (121c) est formée par la surface inférieure de la portion étagée en retrait correspondante (121b), et les portions de bord saillantes (121c) sont encastrées dans le boîtier en résine (11), et
un angle formé par une surface supérieure et une surface inférieure de chacune des portions de bord saillantes (121c) est un angle aigu en coupe transversale verticale par rapport à la surface supérieure de l'électrode de conduction (121a),
**caractérisé en ce que**
les une ou plusieurs paires des portions de bord saillantes (121c) font saillie latéralement dans le boîtier en résine (11) depuis les portions de face de côté de la même électrode de conduction (121a), sur laquelle le dispositif électroluminescent à semi-conducteur (131) est arrimé.

2. Appareil (10) selon la revendication 1, comprenant en outre :
un premier réseau de conducteurs (121) ayant l'électrode de conduction (121a) en tant que première électrode de conduction qui a un plan sensiblement rectangulaire, et est tenu par le boîtier en résine (11) de façon à être au moins partiellement exposé au niveau de la surface inférieure de la portion de coupelle (11a), le dispositif électroluminescent à semi-conducteur (131) étant arrimé sur la première électrode de conduction (121a) avec un adhésif et ayant une électrode ;
un deuxième réseau de conducteurs (122) agencé espacé depuis une surface de côté du premier réseau de conducteurs (121) et ayant une deuxième électrode de conduction (122a) qui est tenu dans le boîtier en résine (11) de sorte que la deuxième électrode de conduction (122a) soit au moins partiellement exposée au niveau de la surface inférieure de la portion de coupelle (11a) ; et
un premier fil mince métallique (142) raccordé électriquement à l'électrode du dispositif électroluminescent à semi-conducteur (131) et à la deuxième électrode de conduction (122a) ;
dans lequel les portions étagées en retrait (121b) sont formées chacune dans des côtés opposés de la surface supérieure de la première électrode de conduction (121a).

3. Appareil (10) selon la revendication 2, comprenant en outre :
un troisième réseau de conducteurs (123) ayant une troisième électrode de conduction (123a) qui est agencé espacé depuis l'autre surface de côté du premier réseau de conducteurs (121) et est tenu dans le boîtier en résine (11) de sorte que la troisième électrode de conduction (123a) soit au moins partiellement exposée au niveau de la surface inférieure de la portion de coupelle (11a) ;
un quatrième réseau de conducteurs (124) ayant une quatrième électrode de conduction (124a) qui est agencé espacé depuis l'autre surface de côté du premier réseau de conducteurs (121) et est tenu dans le boîtier en résine (11) de sorte que la quatrième électrode de conduction (124a) soit au moins partiellement exposée au niveau de la surface inférieure de la portion de coupelle (11a), les portions de bord saillantes (121c) sont à des positions en regard des troisième et quatrième électrodes de conduction (123a, 124a) ;
des premier et second dispositifs électroluminescents (131, 132) arrimés chacun avec un adhésif sur une pluralité de régions de la surface supérieure de la première électrode de conduction (121a), lesquelles régions sont divisées par les portions de bord saillantes (121c), les premier et second dispositifs électroluminescents (131, 132) ayant chacun une paire d'électrodes sur leur surface supérieure, le premier fil fin métallique (142) raccordé par liaison entre l'une de la paire d'électrodes du premier dispositif électroluminescent (131) et la deuxième électrode de conduction (122a) ;
un deuxième fil mince métallique (141) raccordé par liaison entre l'autre de la paire d'électrodes du premier dispositif électroluminescent (131) et la troisième électrode de conduction (123a) ;
un troisième fil mince métallique (144) raccordé par liaison entre l'une de la paire d'électrodes du second dispositif électroluminescent (132) et la deuxième électrode de conduction (122a) ; et
un quatrième fil mince métallique (143) raccordé par liaison entre l'autre de la paire d'électrodes du second dispositif électroluminescent (132) et la quatrième électrode de conduction (124a).

4. Appareil (10) selon l'une quelconque des revendications 1 à 3, **caractérisé en ce que** la surface inférieure des portions étagées en retrait (121b) est en forme d'arc circulaire.

5. Appareil (10) selon l'une quelconque des revendications 1 à 3, **caractérisé en ce que** l'électrode de conduction (121a) est constituée d'un organe métallique, et **en ce que** la profondeur des portions étagées en retrait (121b) est environ la moitié de l'épaisseur de l'électrode de conduction (121a).

6. Appareil (10) selon l'une quelconque des revendications 1 à 3, **caractérisé en ce que** le boîtier en résine (11) a une paroi intérieure (112) entre une surface de bord supérieure de la portion de coupelle (11a) et une portion périphérique la plus extérieure (111) du boîtier en résine (11), la surface supérieure (112a) de la paroi intérieure (112) est positionnée plus basse que la surface inférieure (111a) de la portion périphérique la plus extérieure (111), et le bord supérieur intérieur (112b) de la paroi intérieure (112) est positionné sur ou au-dessus d'une ligne droite (SL) raccordant (a) la ligne d'intersection (IL) de la portion de coupelle (11a) avec la surface supérieure de l'organe de transmission de lumière (15) et (b) le dispositif électroluminescent à semi-conducteur (131).

7. Appareil (10) selon l'une quelconque des revendications 1 à 3, **caractérisé en ce que** la couleur du boîtier en résine (11) est sombre, et **en ce que** le boîtier en résine (11) couvre l'électrode de conduction (121a) autour de la portion arrimée du dispositif électroluminescent à semi-conducteur (131) et du fil métallique (142), à l'exclusion de la portion arrimée du dispositif électroluminescent à semi-conducteur (131) et du fil métallique (142).

8. Procédé de production d'un appareil électroluminescent selon l'une des revendications précédentes, **caractérisé en ce qu'**avant le moulage du boîtier en résine (11) de façon à tenir l'électrode de conduction (121a), un demi-pressage qui sert à presser depuis la surface supérieure de l'électrode de conduction (121a) de façon à former une portion étagée est réalisé pour former les portions étagées en retrait (121b) et les portions de bord saillantes (121c) simultanément dans la même étape.

9. Procédé selon la revendication 8, **caractérisé en ce que** le demi-pressage est réalisé à l'aide d'un plan de pressage (61) ayant une portion de bord en forme d'arc circulaire pour former les portions étagées en retrait (121b) ayant un contour en forme d'arc circulaire sur la surface supérieure de l'électrode de conduction (121a).
